# EUROPÄISCHE PATENTANMELDUNG

(11) **EP 1 303 047 A1**
(43) Veröffentlichungstag der Anmeldung: **16.04.2003**
(21) Anmeldenummer: 02102422.9
(22) Anmeldetag: 08.10.2002
(51) Int. Cl.: H03L 7/089

(54) **Digital schaltbare Stromquelle**

(30) Priorität: 09.10.2001 DE 10149769
(71) Anmelder: Philips Corporate Intellectual Property GmbH, 52064 Aachen (DE); Koninklijke Philips Electronics N.V., 5621 BA Eindhoven (NL)
(72) Erfinder: Bretschneider, Ernst c/o Philips Corp. Int. Prop., 52088, Aachen (DE)
(74) Vertreter: Volmer, Georg, Dipl.-Ing.

(57) **Zusammenfassung**

Um eine digital schaltbare Stromquelle zu schaffen, mittels der zu den Schaltzeitpunkten keine gefährlichen Stromspitzen entstehen, ist vorgesehen, dass zu mindestens zwei parallel angeordneten, mit einer analogen Spannung ansteuerbaren Transistoren (MNn) jeweils zwei digital ansteuerbare Schalttransistoren (MNn1, MNn2) in Reihe geschaltet sind, wobei einer der beiden Schalttransistoren mit dem jeweiligen invertierten Steuersignal geschaltet wird und jeweils einer der beiden Schalttransistoren (MNn1, MNn2) in dem Stromkreis liegt, dessen Strom durch die Stromquelle gesteuert werden soll.

## Beschreibung

Die Erfindung betrifft eine digital schaltbare Stromquelle.

In Elektronikschaltungen werden häufig Konstantstromquellen benötigt, deren Ausgangsstrom nach dem Herstellungsprozeß auf einen bestimmten Wert korrigiert werden muß oder deren Ausgangsstrom innerhalb bestimmter Grenzen variert werden soll.

Bekannt sind unter anderem regelbare Stromquellen, deren Stelltransistor mit einer analogen Regelspannung angesteuert wird oder Konstantstromquellen mit schaltbaren Ausgangsstufen.

Ein allgemeines Problem bei Schaltungen mit zuschaltbaren Konstantströmen ist das Entstehen von Stromspitzen zu den Schaltzeitpunkten, die zur Beschädigung der verwendeten Bauelemente führen oder die Funktion einer nachgeordneten Schaltungsanordnung beeinträchtigen können.

Der Erfindung liegt die Aufgabe zu Grunde, eine digital schaltbare Stromquelle für beliebige Stromwerte anzugeben, bei der zu den Schaltzeitpunkten keine gefährlichen Stromspitzen entstehen.

Erfindungsgemäß wird die Aufgabe gelöst durch die Merkmale des Anspruchs 1. Weitere zweckmäßige Ausgestaltungen sind Gegenstand der Unteransprüche.

Danach sind zu mindestens zwei parallel angeordneten, mit einer analogen Spannung ansteuerbaren Transistoren jeweils zwei digital ansteuerbare Schalttransistoren in Reihe geschaltet, zwischen deren Steuerelektroden (Gate) jeweils ein Element zur Signalinvertierung geschaltet ist, wobei einer der beiden Schalttransistoren in dem Stromkreis liegt, dessen Strom durch die Stromquelle gesteuert werden soll. Der jeweils parallele zweite, invers angesteuerte Schalttransistor dient zur Unterdrückung der Stromspitzen - sogenannten Spikes - im Umschaltmoment.

Die Erfindung hat den Vorteil, dass sich ein Ausgangsstrom definierter Größe generieren läßt. Die Stromquelle kann aus einer beliebigen Zahl von einzelnen Konstantstromquellen mit den dazugehörigen Schalttransistoren bestehen. Das Größenverhältnis dieser Stromquellen untereinander kann unterschiedlich gewichtet werden, also zum Beispiel binär oder digital. Die Größe des generierten Stromes ergibt sich als Summe aus den aktiv geschalteten Pfaden.

Die Erfindung soll nachstehend anhand eines Ausführungsbeispiels näher erläutert werden. In den zugehörigen Zeichnungen zeigen:
- Fig. 1: ein Prinzipschaltbild der erfindungsgemäßen Stromquelle und
- Fig. 2: ein Anwendungsbeispiel der Stromquelle bei einer PLL-Schaltung.

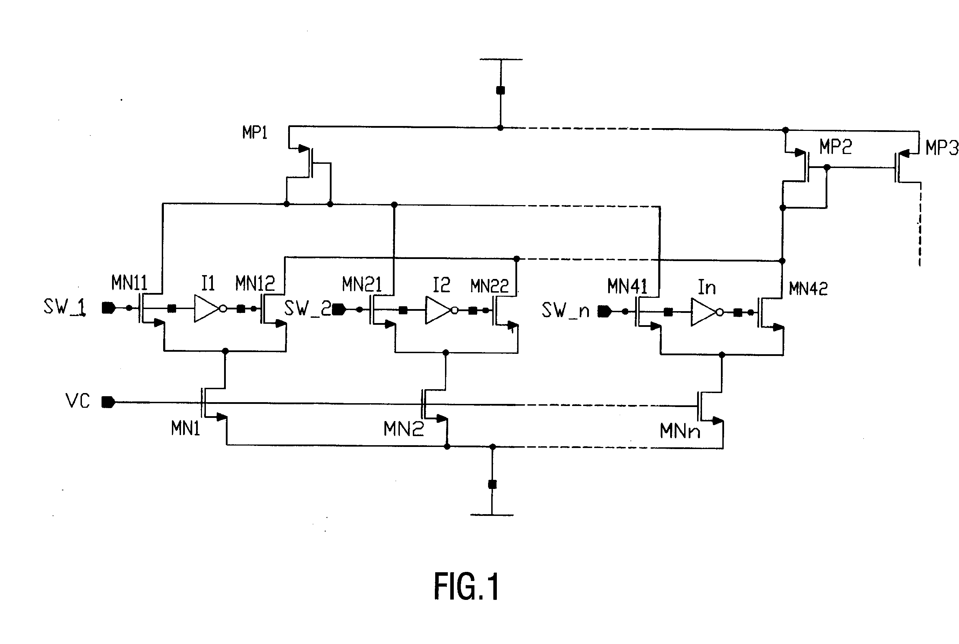

Fig. 1 zeigt das Prinzip der Stromquelle. Die Stromquelle besteht aus mehreren, von einer gemeinsamen analogen Spannung VC angesteuerten Stelltransistoren MN1 .. MNn, die als Stromquelle arbeiten. In Reihe mit jedem Stelltransistor befinden sich jeweils zwei Schalttransistoren MN11 und MN12 bis MNn1 und MNn2, deren Steuerelektroden (Gate) mit einem digitalen Signal an Schalteingängen SW_1 bis SW_n bzw. dessen Invertierung angesprochen werden. Die Ausgänge der Schalttransistoren sind entweder mit dem Lasttransistor MP1 oder MP2 verbunden, so dass zwei alternative Strompfade entstehen. Durch Anlegen eines High-Signals an die Schalteingänge SW_1...SW_n wird jeweils von einem Strom durch den Transistor MP1 auf einen Strompfad durch den Transistor MP2 umgeschaltet und bei Low-Signal wieder zurückgeschaltet, da infolge der Invertierung durch Inverter I1...In, die zwischen den Steuerelektroden jeweils der zwei mit jedem der Stelltransistoren in Reihe geschalteten Schalttransistoren MN11 und MN12 bis MNn1 und MNn2 angeordnet sind, immer einer der Schalttransistoren MN11, MN22...MNn1, MNn2 auf Durchlaß gesteuert ist. Da so der Stromfluß durch die Transistoren MN1 ... MNn nicht unterbrochen wird, treten zu den Umschaltzeitpunkten keine Stromspitzen auf. Transistor MP2 ist als Ausgang der Schaltung zu betrachten, mit dem ein Transistor MP3 gesteuert werden kann. Die Stromstärke am Ausgang ergibt sich immer als Summe aus den Strömen derjenigen der Transistoren MN1...MNn, die durch ein High-Signal an den Schalteingängen SW1...SWn auf den Strompfad durch den Transistor MP2 geschaltet sind.

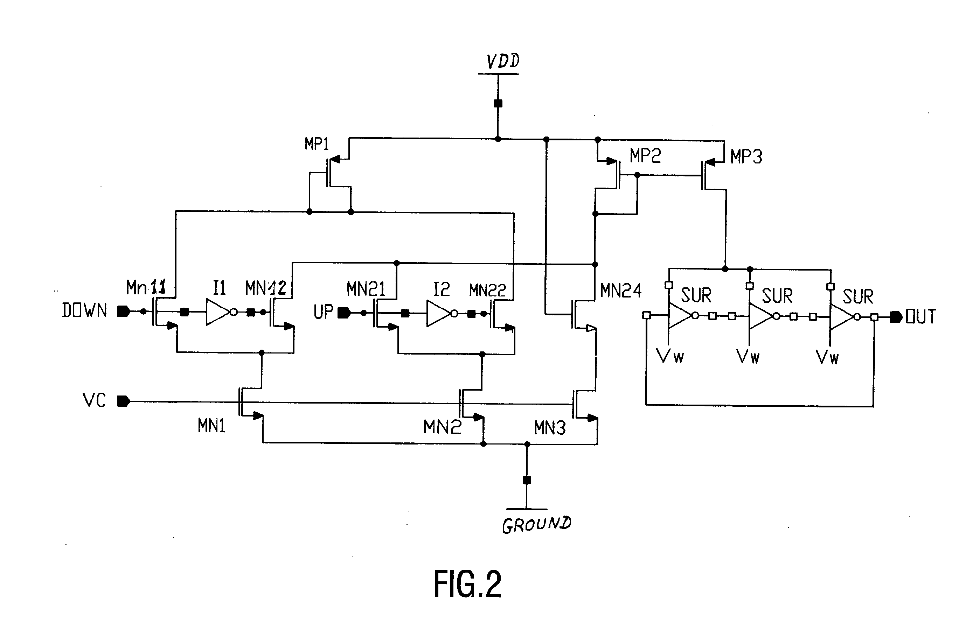

Fig. 2 zeigt eine mögliche Anwendung der Stromquelle für eine PLL-Schaltung (Phase-Locked-Loop). Eine PLL-Schaltung ist eine frequenzselektive Schaltung, bei der ein Phasendetektor, ein Filter, ein Verstärker und ein spannungsgesteuerter Oszillator (VCO) zu einem Regelkreis zusammengeschaltet sind. Die Steuerspannung VC des Oszillators wird mittels einer Modifikation der oben beschriebenen digital schaltbaren Stromquelle in einen äquivalenten Strom umgewandelt und über drei mögliche Pfade dem Ausgangstransistor MP2 zugeführt, welcher damit die Frequenz des Oszillators beeinflußt. Die digitalen Signale UP und DOWN, die aus der Phasendifferenz von Soll- und Istwert der Ausgangsfrequenz generiert werden, beeinflussen durch die Schalttransistoren MN11, MN12 bzw. MN21 und MN22 den Strom durch den Ausgangstransistor MP2 und damit das Einschwingverhalten der PLL.

Stimmen Soll- und Istwert der Frequenz überein, ist die Phasendifferenz Null und die Signale UP und DOWN befinden sich auf Massepotential (GROUND). Der Strom, der den VCO versorgt, fließt durch die Pfade MN1, MN12, MP2 sowie MN3, MN24, MP2. Weicht die Frequenz des VCO nach oben ab, wird das Signal DOWN auf Versorgungspotential (VDD) gesetzt, öffnet damit den Transistor MN11 und sperrt den Transistor MN12. Der Strom des Transistors MN1 fließt nun über den Pfad MN11, MP1 und reduziert damit den Gesamtstrom des Transistors MP2 und damit die Frequenz des VCO. Im umgekehrten Fall, d. h. wenn die Ausgangsfrequenz zu niedrig ist, wird das Signal UP auf VDD-Niveau gesetzt und der Oszillator bekommt für die Dauer dieses Signals einen erhöhten Strom über den Pfad MN2, MN21, MP2 zugeführt.

Der Vorteil der Schaltung liegt neben der Verkürzung der Einschwingzeit der PLL insbesondere in der Reduzierung des Frequenzjitters des Oszillators auf Grund der Vermeidung von Stromspitzen während der Schaltzeitpunkte.

### BEZUGSZEICHENLISTE

- MNn: Transistor
- MNn1: Schalttransistor
- MNn2: Schalttransistor
- MPn: Transistor
- In: Inverter
- VC: Ansteuerspannung
- VCO: Oszillator
- SW_n: Schalteingang

## Patentansprüche

1. Digital schaltbare Stromquelle,
**dadurch gekennzeichnet,**
**dass** zu mindestens zwei in je einem Zweig parallel angeordneten, mit einer analogen Spannung steuerbaren Stromquellentransistoren (MNn1) jeweils zwei mit einem digitalen Steuersignal ansteuerbare Schalttransistoren (MNn1, MNn2) in Reihe geschaltet sind.

2. Digital schaltbare Stromquelle nach Anspruch 1,
**dadurch gekennzeichnet,**
**dass** das jeweilige digitale Steuersignal eines jeden Zweiges jeweils einem der beiden Schalttransistoren invertiert zugeführt wird.

3. Digital schaltbare Stromquelle nach Anspruch 1 oder 2,
**dadurch gekennzeichnet,**
**dass** die Ausgänge der Schalttransistoren entweder in den zu steuernden Strompfad oder in einen parallelen, lastäquivalenten, passiven Strompfad münden.
